## Europäisches Patentamt
## European Patent Office
## Office européen des brevets

(19)

(11) Veröffentlichungsnummer: **0 111 749**
**B1**

(12) **EUROPÄISCHE PATENTSCHRIFT**

(45) Veröffentlichungstag der Patentschrift:
**01.03.89**

(21) Anmeldenummer: **83111369.1**

(22) Anmeldetag: **14.11.83**

(51) Int. Cl.⁴: **H 01 L 31/02**

(54) Verfahren zum Herstellen von elektrische Kontakte bildende Fingerelektrodenstrukturen an amorphen Silizium-Solarzellen.

(30) Priorität: **19.11.82 DE 3242791**

(43) Veröffentlichungstag der Anmeldung:
**27.06.84 Patentblatt 84/26**

(45) Bekanntmachung des Hinweises auf die Patenterteilung:
**01.03.89 Patentblatt 89/9**

(84) Benannte Vertragsstaaten:
**DE FR GB IT**

(56) Entgegenhaltungen:
**EP-A- 0 060 363**
**DE-B- 1 283 975**
**US-A- 4 171 989**

**THE CONFERENCE RECORD OF THE 14TH IEEE PHOTOVOLTAIC SPECIALISTS CONFERENCE, San Diego, CA, US, 7.-10. Januar 1980, Seiten 948-951, IEEE, New York, US; J.R. ANDERSON et al.: "Nickel contacts for low cost solar cells"**

(73) Patentinhaber: **Siemens Aktiengesellschaft Berlin und München, Wittelsbacherplatz 2, D-8000 München 2 (DE)**

(72) Erfinder: **Möller, Matthias, Dipl.-Phys., Plievierpark 12, D-8000 München 83 (DE)**
Erfinder: **Kausche, Helmold, Dipl.-Phys., Tessinerstrasse 146, D-8000 München 71 (DE)**

ACTORUM AG

## Beschreibung

Die Patentanmeldung betrifft ein Verfahren zum Herstellen von elektrische Kontakte bildenden Fingerelektrodenstrukturen an aus amorphen Siliziumschichten bestehenden Solarzellen, bei dem die die Fingerelektroden bildenden Metallschichten zur Verwendung von den gewünschten Strukturen entsprechenden Masken auf die Oberfläche aufgedampft werden.

Bisher wurden Fingerelektrodenstrukturen auf Solarzellen aus amorphem Silizium (= a–Si) und aus einkristallinem Silizium durch Aufdampfen von ca. 1 μm dicken Silberschichten hergestellt. Ein solches Verfahren ist beispielsweise aus der deutschen Auslegeschrift 2 411 690 für Solarzellen aus einkristallinem Silizium bekannt.

Aus US-A-4 171 989 ist ein Verfahren zur Herstellung von Elektroden auf Silizium-Solarzellen bekannt, bei dem eine Nickelstruktur abgeschieden wird und durch Tauchlötverzinnung verdickt wird.

Solarzellen aus einkristallinem Silizium sind relativ teuer, so daß der Preis des aus Silber bestehenden Kontaktsystems kaum ins Gewicht fällt. Durch die Verwendung von amorphem Silizium als Halbleitermaterial für Solarzellen ist die Möglichkeit gegeben, eine besonders kostengünstige Dünnschicht-Solarzelle herzustellen. Hier spielt der Preis für die der Stromableitung dienenden Fingerelektroden bereits eine große Rolle.

Aufgabe der Erfindung ist es daher, Fingerelektrodenstrukturen an aus amorphem Silizium bestehenden Solarzellen möglichst niederohmig und möglichst kostengünstig herzustellen. Daneben soll gewährleistet sein, daß bei Solarzellen des Typs pin/ITO (Indium-Zinn-Oxid) während der Herstellung der Kontakte keine Beeinträchtigung der als Antireflexschicht dienenden ITO-Schicht stattfindet und das Bauelement nicht thermisch belastet wird.

Diese Aufgabe wird durch ein Verfahren der eingangs genannten Art gelöst, welches durch die Abfolge der folgenden Verfahrensschritte gekennzeichnet ist:

a) Aufdampfen einer Chrom-Nickel-Schicht,
b) Aufdampfen einer reinen Nickelschicht,
c) Entfernen der Bedampfungsmaske,
d) Tauchen der Anordnung in mild-aktiviertes Kolophonium-Flußmittel und
e) Tauchen in eine bei 210 bis 230 °C schmelzflüssige Zinnlegierung.

In einer Weiterbildung des Erfindungsgedankens ist vorgesehen zum Tauchlötverzinnen eine aus Zinn und Blei im Verhältnis von etwa 3 : 2 bestehende Schmelze mit einem Anteil von 2% Silber zu verwenden und die Temperatur beim Verzinnen auf 220 °C einzustellen.

Gegenüber den bekannten Aufdampfverfahren mit Silber stellt das Tauchverzinnungsverfahren, bei dem erfindungsgemäß als Grundschicht zum Verzinnen eine Nickel-Chrom/Nickel-Schicht verwendet wird, hinsichtlich des Kriteriums der Preiskosten und des Kriteriums der Niederohmigkeit einen technischen Fortschritt dar. Es liegt im Rahmen der Erfindung, zur Haftvermittlung eine Chrom-Nickel-Schicht der Zusammensetzung 20 : 80 in einer Schichtdicke von 100 nm und darauf als lötbare Schicht eine 150 bis 200 nm, vorzugsweise 170 nm dicke Nickelschicht aufzudampfen.

Zur Verhinderung einer Oxidation der Nickelschicht wird gemäß einem besonders günstigen Ausführungsbeispiel nach der Lehre der Erfindung zusätzlich eine 100 nm dicke Silberschicht aufgedampft.

Als mild-aktiviertes Kolophonium-Flußmittel wird insbesondere für eine pin/ITO-Solarzelle Multicore 5381 (Fa. Multicore Ltd.) verwendet. Stärker aktivierte Flußmittel greifen die ITO-Schicht an, nicht aktivierte dagegen führen zu keiner ausreichenden Benetzung der Nickel-·schicht.

Der Vorteil der Erfindung liegt neben einer kostengünstigen Herstellung der Fingerelektroden · in einer Optimierung der elektrischen Werte. Die resultierenden Widerstände sind 1 Ohm auf den 20 mm langen und 0,1 bis 0,2 mm breiten Stegen und 90 m Ohm auf dem 2 bis 4 mm breiten Mittelsteg. Dies entspricht ungefähr einem Drittel des Wertes, der mit einer 1 μm dicken Silberschicht erhalten wurde.

Im folgenden wird anhand der Figuren 1 bis 3 die Erfindung noch näher erläutert. Dabei zeigt

die Figur 1 in perspektivischer Darstellung eine großflächige pin-Solarzelle mit einem tauchverzinnten Kontaktsystem (Fingerelektrodenstrukturen),

die Figur 2 im Schnitt den Aufbau einer Solarzelle (pin/ITO-Zelle), für die das erfindungsgemäße Verfahren mit Vorteil verwendet wird und

die Figur 3 die Kennlinie der Solarzelle (Kurve II).

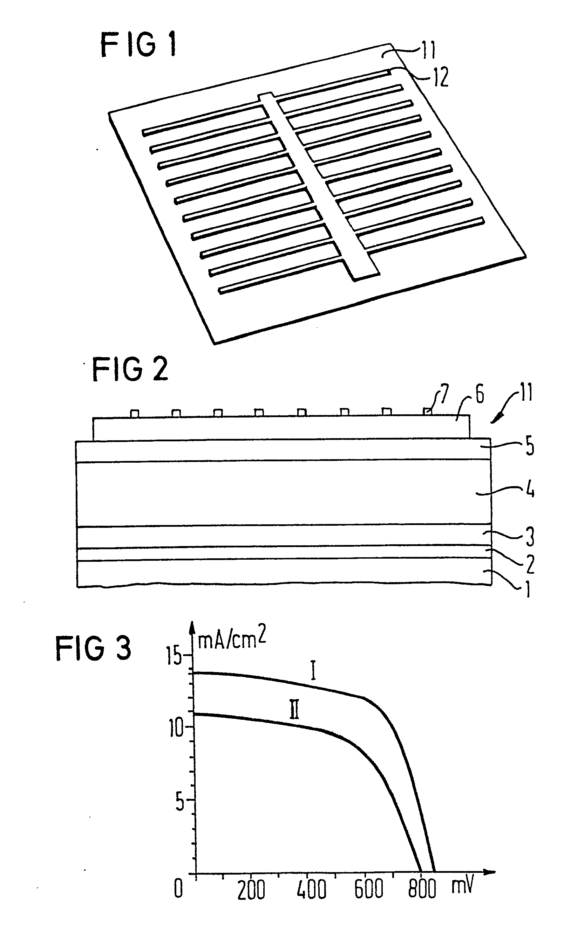

In den Figuren 1 und 2 sind für gleiche Elemente gleiche Bezugszeichen verwendet.

Die aus Figur 1 ersichtliche Strukturierung der Aufdampfschichten nach dem Fingerelektrodenmuster wird mit Hilfe von Bedampfungsmasken hergestellt. Die Verzinnung (Schicht 12) erfolgt durch Tauchen der Anordnung 11 in eine Schmelze der Zusammensetzung 59% Zinn, 39% Blei und 2% Silber bei einer Temperatur von 220 °C. Die pin/ITO-Solarzelle (11) wurde dazu vorher in mild-aktiviertes Kolophonium-Flußmittel getaucht.

In Figur 2 ist mit dem Bezugszeichen

1 = der Substratkörper zum Beispiel aus Glas,
2 = die Rückkontaktschicht aus Aluminium/ Silizium bzw. Aluminium/Silizium/Titan (750 nm),
3 = amorphe Siliziumschicht (p-dotiert, 20 nm)
4 = amorphe Siliziumschicht (Intrinsic, 500 nm),
5 = amorphe Siliziumschicht (n-dotiert, 10 nm),
6 = Indium-Zinn-Oxid-Schicht (ITO-Schicht = Antireflexschicht, 70 nm) und
7 = Fingerelektrodenstruktur aus Nickel/ Chrom-Nickel (270 nm) und Silber (100 nm)
bezeichnet.

Figur 3: Hier ist die Kennlinie der nach dem erfindungsgemäßen Verfahren hergestellten Solarzelle unter AM1-Beleuchtung (Verwendung eines Sonnensimulators) dargestellt. Die Zelle (Kurve II) ist kurzschlußfrei (entsprechend der geringen Abnahme der Leerlaufspannung bei schwacher Beleuchtung) und zeigt denselben Wirkungsgrad $\eta$ wie Zellen auf kleinen Flächen (siehe Kurve I, 6 mm², die parallel hierzu, jedoch ohne die Elektrodenstruktur hergestellt worden sind. Daraus folgt, daß der Leistungsverlust in der Elektrodenstruktur vernachlässigbar klein ist. Die Leistungsverluste, die von dem Widerstand des Elektrodengitters, des Mittelbalkens und der ITO-Schicht beigetragen werden, wurden berechnet und den Werten, die aus einer Elektrodenstruktur mit einer aufgedampften Silberschicht (1 µm) herrühren, gegenübergestellt. Das Ergebnis ist aus der nachfolgenden Tabelle 1 zu entnehmen.

Tabelle 1:

| Leistungsverlust in % der Gesamtausgangsleistung | | ITO | Gitter | Mittel-balken | Gesamt |
|---|---|---|---|---|---|
| a) | 0,2 mm Sn tauchver-zinnter Kontakt | 1,3% | 0,4% | 0,7% | 2,4% |
| b) | 1 µm AG aufgedampf-ter Kontakt | 1,3% | 0,8% | 3% | 5,1% |

Daraus ergibt sich, daß bei vierfacher Zellengröße der Beitrag des Mittelbalkens sich verdoppeln würde, das heißt, der gesamte Leistungsverlust sich bei a) und b) auf 3% bzw. auf 8% erhöhen, also zugunsten des Falles b) sich verschieben würde, was die Verwendung tauchgelöteter Kontakte hier noch wichtiger macht.

Tabelle 2 zeigt die zu den Kennlinien I und II der Figur 3 gehörenden Werte für den Wirkungsgrad $\eta$, die Leerlaufspannung $V_{oc}$, den Kurzschlußstrom $I_{sc}$ und den Füllfaktor FF.

Tabelle 2:

| | I | II | |
|---|---|---|---|
| $\eta$ | 7,4 | 5 | % |
| $V_{oc}$ | 839 | 800 | mV |
| $I_{sc}$ | 13,78 | 10,9 | mA/cm² |
| FF | 64 | 57 | % |

## Patentansprüche

1. Verfahren zum Herstellen von elektrische Kontakte bildende Fingerelektrodenstrukturen (7, 12) an aus amorphen Siliziumschichten bestehenden Solarzellen (11), bei dem die die Fingerelektroden bildenden Metallschichten (7) unter Verwendung von den gewünschten Strukturen entsprechenden Masken aufgedampft werden, gekennzeichnet durch die Abfolge der folgenden Verfahrensschritte:
   a) Aufdampfen einer Chrom-Nickel-Schicht,
   b) Aufdampfen einer reinen Nickelschicht,
   c) Entfernen der Bedampfungsmaske,
   d) Tauchen der Anordnung in mild-aktiviertes Kolophonium-Flußmittel,
   e) Tauchen in eine bei 210 bis 230 °C schmelzflüssige Zinnlegierung (12).

2. Verfahren nach Anspruch 1, dadurch gekennzeichnet, daß zum Verzinnen (12) eine aus Zinn und Blei im Verhältnis 3 : 2 bestehende Schmelze mit einem Anteil von 2% Silber verwendet wird und die Temperatur auf 220 °C eingestellt wird.

3. Verfahren nach Anspruch 1 und 2, dadurch gekennzeichnet, daß nach Verfahrensschritt a) eine Chrom-Nickel-Schicht mit der Zusammensetzung 20 : 80 verwendet wird und die Schichtdicke auf 100 nm eingestellt wird.

4. Verfahren nach Anspruch 1 bis 3, dadurch gekennzeichnet, daß nach Verfahrensschritt b) die Dicke der reinen Nickelschicht auf 150 bis 200 nm eingestellt wird.

5. Verfahren nach Anspruch 1 bis 4, dadurch gekennzeichnet, daß im Anschluß an Verfahrensschritt b) zusätzlich eine Silberschicht in einer Schichtdicke von 100 nm aufgedampft wird.

6. Verfahren nach Anspruch 1 bis 5, dadurch gekennzeichnet, daß die Schichtdicke beim Tauchverzinnen (12) nach Verfahrensschritt e) auf 0,01 bis 0,5 mm eingestellt wird.

7. Verwendung des Verfahrens nach Anspruch 1 bis 6 zur Herstellung von amorphen Silizium-Solarzellen des Typs pin mit einer aus Indium-Zinn-Oxid (= ITO) bestehenden Antireflexschicht.

## Claims

1. A process for the production of finger electrode structures (7, 12) which form electrical contacts on solar cells (11) consisting of amorphous silicon layers, where the metal layers (7) which form the finger electrodes are vapour deposited using masks which correspond to the desired structures, characterised by the sequence of the following process steps:
   a) vapour deposition of a chromium-nickel layer,
   b) vapour deposition of a pure nickel layer,
   c) removal of the vapour deposition mask,
   d) dipping of the arrangement into mildly activated colophonium flux,
   e) dipping into a molten tin alloy (12) the temperature of which is 210 to 230 °C.

2. A process as claimed in Claim 1, characterised in that for the tinning (12), a melt consisting of tin and lead in a ratio of 3 : 2 with a constituent of 2% silver is used, and the temperature is set at 220 °C.

3

3. A process as claimed in Claim 1 and 2, characterised in that in accordance with process step a), a chromium-nickel layer having a composition ratio of 20 : 80 is used and the layer thickness is set at 100 nm.

4. A process as claimed in Claim 1 to 3, characterised in that in accordance with process step b), the thickness of the pure nickel layer is set at 150 to 200 nm.

5. A process as claimed in Claim 1 to 4, characterised in that after process step b), a silver layer with a layer thickness of 100 nm is additionally vapour deposited.

6. A process as claimed in Claim 1 to 5, characterised in that the layer thickness for the dip tinning (12) according to process step e) is set at 0.01 to 0.5 mm.

7. The use of the process claimed in Claim 1 to 6 for the production of amorphous silicon solar cells of the pin type with an anti-reflective layer made of indium-tin-oxide (= ITO).

**Revendications**

1. Procédé de fabrication de structures digitées d'électrodes (7, 12), formant des contacts électriques sur des cellules solaires (11) constituées de couches de silicium amorphe, dans lequel les couches métalliques (7) formant les électrodes digitées sont déposées à phase vapeur en utilisant des masques correspondant aux structures souhaitées, caractérisé par la succession des stades de procédés suivants:

a) dépôt en phase vapeur d'une couche chrome-nickel,

b) dépôt en phase vapeur d'une couche de nickel pur,

c) élimination du masque de dépôt en phase vapeur,

d) immersion du dispositif dans un flux de colophane activé modérément,

e) immersion dans un alliage d'étain (12) fusible entre 210 et 230 °C.

2. Procédé suivant la revendication 1, caractérisé en ce qu'il consiste à utiliser, pour l'étamage (12), un bain fondu constitué d'étain et de plomb, dans le rapport 3 : 2 et ayant une proportion de 2% d'argent, et à régler la température à 220 °C.

3. Procédé suivant la revendication 1 ou 2, caractérisé en ce qu'il consiste à utiliser, après le stade a) du procédé, une couche de chrome-nickel de composition 20 : 80 et à régler l'épaisseur de la couche à 100 nm.

4. Procédé suivant l'une des revendications 1 à 3, caractérisé en ce qu'il consiste à régler, après le stade b) du procédé, l'épaisseur de la couche pure de nickel entre 150 et 200 nm.

5. Procédé suivant l'une des revendications 1 à 4, caractérisé en ce qu'il consiste, à la suite du stade b) du procédé, à déposer, en plus, en phase vapeur une couche d'argent en une épaisseur de 100 nm.

6. Procédé suivant l'une des revendications 1 à 5, caractérisé en ce qu'il consiste à régler l'épaisseur de la couche, lors de l'étamage par immersion (12), après le stade e) du procédé, entre 0,01 et 0,5 mm.

7. Utilisation du procédé suivant l'une des revendications 1 à 6, pour la fabrication de cellules solaires en silicium amorphe, du type pin, ayant une couche anti-reflet en oxyde d'indium et d'étain (ITO).

## FIG 1

## FIG 2

## FIG 3